# EUROPÄISCHE PATENTSCHRIFT

(11) **EP 0 966 190 B1**
(45) Veröffentlichungstag und Bekanntmachung des Hinweises auf die Patenterteilung: **15.12.2004**
(21) Anmeldenummer: 99112098.1
(22) Anmeldetag: 17.06.1999
(51) Int. Cl.: H05K 9/00

(54) **Vorrichtung zum Bewerkstelligen einer Schirmung in Kunststoffgehäusen**
Device for achieving shielding in a plastic casing
Procédé pour la mise en oeuvre d'un blindage dans un boîtier en plastique

(30) Priorität: 17.06.1998 DE 19827025
(43) Veröffentlichungstag der Anmeldung: 22.12.1999
(73) Patentinhaber: Fujitsu Siemens Computers GmbH, 80807 München (DE)
(72) Erfinder: Köhler, Friedrich, 86405 Meitingen (DE)
(74) Vertreter: Epping, Hermann, Fischer

(56) Entgegenhaltungen:
- DE-A- 19 517 338
- US-A- 3 234 318
- PATENT ABSTRACTS OF JAPAN vol. 1996, no. 12, 26. Dezember 1996 (1996-12-26) & JP 08 213785 A (MITSUBISHI ELECTRIC CORP), 20. August 1996 (1996-08-20)

## Beschreibung

Die Erfindung betrifft eine Vorrichtung zum Bewerkstelligen einer Schirmung in Kunststoffgehäusen gemäß dem Oberbegriff des einzigen Anspruchs.

Gehäusen, beispielsweise solchen für Personal Computer, werden heutzutage aus Kunststoffteilen gefertigt, die keine Schirmwirkung gegen elektrische Störstrahlungen sowohl von innen nach außen als auch von außen nach innen haben.

Auf den Innenseiten der Kunststoffgehäuseteile können Schirmbleche verwendet sein, um eine Schirmung gegen Störstrahlungen zu bewerkstelligen. Die Schirmbleche sind dabei an den Kunststoffgehäuseteilen entweder angeschraubt oder eingeklebt.

Nachteilig dabei ist, dass die Montage der Schirmbleche aufwendig ist und dass die Befestigung keine Ausgleichsbewegungen zwischen Schirmblech und Gehäuseteil zulässt.

Aufgabe der Erfindung ist daher, eine Vorrichtung der eingangs genannten Art anzugeben, bei der Ausgleichsbewegungen zwischen Gehäuseteil und Schirmblech möglich sind und bei der die Montage des Schirmblechs einfach ist.

Diese Aufgabe wird durch die Merkmale des einzigen Anspruchs gelöst.

Danach sind an den Gehäuseteilen eines Kunststoffgehäuses innenseitig Befestigungsstifte angeformt, die durch Öffnungen eines lose in das Gehäuseteil eingelegten Schirmblechs greifen, und danach sind weiter über die angeformten Befestigungsstifte geschobene Krallscheiben vorgesehen, die ein vor dem Aufschieben auf die Befestigungsstifte lose in das Gehäuseteil eingelegtes Schirmblech elastisch halten.

Nachfolgend wird ein Ausführungsbeispiel der Erfindung anhand einer Zeichnung näher erläutert. Darin zeigen
- Figur 1: ein Gehäuseteil mit innenseitig angeordneter Vorrichtung zum Bewerkstelligen einer Schirmung gemäß der Erfindung in perspektivischer Darstellung, und
- Figur 2: einen Befestigungsstift aus der Figur 1 in Schnittdarstellung entlang der Linie A,
- Figur 3: eine Krallscheibe gemäß der Figur 1 bzw. 2 in Einzeldarstellung.

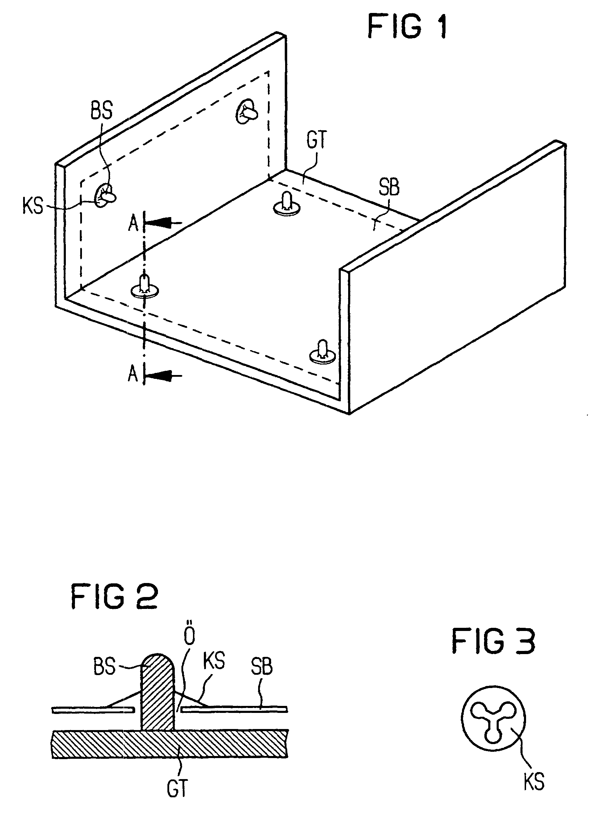

Figur 1 zeigt ein Gehäuseteil GT, das aus Kunststoff besteht. Das Gehäuseteil GT ist U-förmig ausgebildet und könnte beispielsweise eine Unterschale eines Kunststoffgehäuses für einen Personal Computer sein.

Das Gehäuseteil GT weist auf seinen Innenseiten ein metallisches Schirmblech SB auf, das der Form des äußeren Gehäuseteils GT angepasst ist. Das Schirmblech SB ist in der Figur 1 durch gestrichelte Linien angezeigt.

Auf den Innenseiten des Gehäuseteils GT sind Befestigungsstifte BS angeformt. Die Befestigungsstifte BS sind im vorliegenden Ausführungsbeispiel direkt aus dem Material des Gehäuseteils GT geformt.

Nach einem losen Einlegen des Schirmblechs SB in das Gehäuseteil GT greifen die Befestigungsstifte BS durch Öffnungen Ö des Schirmblechs SB.

Krallscheiben KS sind über die Befestigungsstifte BS geschoben und halten das vorher eingelegte Schirmblech SB elastisch fest.

In der Figur 2 ist im Bereich eines Befestigungsstiftes BS ein Schnitt zu sehen, der das Gehäuseteil GT, das Schirmblech SB und die Krallscheibe KS zeigt. Der Schnitt verläuft entlang der Linie A in der Figur 1.

Das Schirmblech SB ist auf das Gehäuseteil GT gelegt. Der Befestigungsstift BS greift durch eine Öffnung Ö im Schirmblech SB. Die Krallscheibe KS ist auf den Befestigungsstift BS geschoben.

Die Krallscheibe verhindert, dass das Schirmblech SB vom Befestigungsstift BS rutscht. Ist die Öffnung Ö des Schirmblechs SB mit geeigneten Maßen gefertigt, kann das Schirmblech SB in der Ebene Ausgleichsbewegungen ausführen. Damit können Spannungen zwischen dem Gehäuseteil GT und dem Schirmblech vermieden werden.

Die Krallscheibe KS in der Figur 3 ist in Draufsicht zu sehen. Sie hat symmetrisch zur Mitte im Kreis angeordnet drei größere Bohrungen, die zur Mitte hin mit kleineren geöffneten Stegen verbunden sind. Im Zentrum ist eine weitere Bohrung vorgesehen, die einen etwas kleineren Durchmesser hat als der Durchmesser der Befestigungsstifte BS aus den Figuren 1 und 2. Damit sind zwischen den größeren Bohrungen Zungen ausgebildet, die beim Aufschieben der Krallscheibe KS auf einen Befestigungsstift BS entgegen der Aufschubrichtung ausweichen, wodurch der Durchmesser der zentralen Bohrung aufgeweitet wird, bis der Befestigungsstift durch die Krallscheibe KS passt. Ist die Krallscheibe auf den Befestigungsstift aufgeschoben, stützen sich die Zungen der Krallscheibe schräg am Befestigungsstift ab. Ein Abziehen der Krallscheibe bewirkt, dass die nicht am Befestigungsstift BS entlanggleitbaren Zungen wieder entgegen der Abziehrichtung ausgelenkt werden, wodurch der Durchmesser der zentralen Bohrung verkleinert wird und sich die Zungen noch mehr am Befestigungsstift BS abstützen.

Insgesamt ist auf diese Weise ein einfaches und elastisches Befestigen des Schirmblechs SB möglich. Für eine Demontage können die Zungen der Krallscheiben KS aufgebogen werden.

Ein montiertes Schirmblech SB stellt eine Schirmung gegen elektrische Störstrahlungen dar.

## Patentansprüche

1. Vorrichtung zum Bewerkstelligen einer Schirmung in Kunststoffgehäusen mit wenigstens einem Gehäuseteil aus Kunststoff, **dadurch gekennzeichnet, dass** an den aus Kunststoff bestehenden Gehäuseteilen (GT) innenseitig Befestigungsstifte (BS) angeformt sind, die durch Öffnungen (Ö) eines lose in das Gehäuseteil (GT) eingelegten Schirmblechs (SB) greifen, und dass über die angeformten Befestigungsstifte (BS) Krallscheiben (KS) geschoben sind, die das vor dem Aufschieben der Krallscheiben (KS) auf die Befestigungsstifte (BS) lose in das Gehäuseteil (GT) eingelegte Schirmblech (SB) elastisch halten.

## Claims

1. Device for achieving shielding in plastic casings with at least one casing part of plastic, **characterized in that** formed on the inside of the casing parts (GT) consisting of plastic are fixing pins (BS), which reach through openings (Ö) in a shielding plate (SB) placed loosely into the casing part (GT), and **in that** claw-like discs (KS) are pushed over the formed-on fixing pins (BS) and flexibly hold the shielding plate (SB) which has been placed loosely into the casing part (GT) before the said claw-like discs (KS) are pushed onto the fixing pins (BS).

## Revendications

1. Dispositif pour réaliser un blindage dans des boîtiers en matière plastique comportant au moins une pièce de boîtier en matière plastique, **caractérisé en ce qu'**il est issu de la face intérieure des pièces (GT) de boîtier en matière plastique des broches (BS) de fixation qui passent dans des ouvertures (Ö) d'une tôle (SB) de blindage insérée dans la pièce (GT) de boîtier, et **en ce qu'**il est enfilé sur les broches (BS) de fixation issues de la pièce de boîtier des rondelles (KS) formant crampon qui maintiennent de manière élastique la tôle (SB) de blindage, insérée avant l'enfilage de la rondelle (KS) formant crampon sur les broches (BS) de fixation, de manière lâche dans la pièce (GT) de boîtier.
